Europäisches Patentamt

European Patent Office

Office européen des brevets

(11) Publication number: **0 407 697 A1**

# EUROPEAN PATENT APPLICATION

(21) Application number: **90108448.3**

(51) Int. Cl.⁵: **G11C 11/40**

(22) Date of filing: **04.05.90**

(30) Priority: **10.07.89 JP 177375/89**
　　　　　**21.08.89 JP 214414/89**

(43) Date of publication of application:
**16.01.91 Bulletin 91/03**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Takeda, Koji, c/o Seiko Epson**
**Corporation**
**3-5, Owa 3-chome**
**Suwa-shi, Nagano-ken(JP)**

(74) Representative: **Blumbach Weser Bergen**
**Kramer Zwirner Hoffmann Patentanwälte**
**Radeckestrasse 43**
**D-8000 München 60(DE)**

(54) Memory apparatus.

(57) In this invention, a $W(1 + J/N)$ (words) x D (bits) memory apparatus is constituted by $(N + J)$ ($N = D/B = 2^{d-b}$; J is a positive integer satisfying $J < N$) semiconductor memory elements (M1 - M5) each having a W (words) x B (bits) ($W = 2^w$ where w is a positive integer; $B = 2^b$ where b is zero or a positive integer satisfying $b < d$) configuration. For example, five 256K x 4 1M DRAMs are used, so that four (M1 - M4) out of five DRAMs always correspond to access from a microprocessor. Furthermore, a 640-Kbyte memory address space is equally divided into five 128-Kbyte memory address areas, and the correspondence between the 128-Kbyte memory address areas and four out of the five DRAMs is regularly determined in turn, thus constituting a 640-Kbyte memory apparatus (320 Kwords x 16 bits) by only the 1M DRAMs. More specifically, a memory capacity can be set in relatively small units, i.e., in units of $W \cdot J/N$ words x D bits by using only semiconductor memory elements of one type.

EP 0 407 697 A1

Fig. 1B

## MEMORY APPARATUS

BACKGROUND OF THE INVENTION :

Field of the Invention

The present invention relates to a memory apparatus for a personal computer and, more particularly, to a memory apparatus constituted by using a plurality of semiconductor memory elements.

Description of the Related Art

A memory apparatus having a 16-bit data bus width can be constituted by using a plurality of semiconductor elements having the same structure.

For example, a 256 (Kwords) x 16 (bits) (512 Kbytes) memory apparatus can be constituted by four 256 (Kwords) x 4 (bits) semiconductor memory elements; a 512 (Kwords) x 16 (bits) (1 Mbyte) memory apparatus by 8 memory elements; a 768 (Kwords) x 16 (bits) (1.5 Mbytes) memory apparatus by 12 memory elements; and a 1024 (Kwords) x 16 (bits) (2 Mbytes) memory apparatus by 16 memory elements. In this case, every time the number of memory elements is increased by four, a memory capacity can be increased in units of 512 Kbytes.

For example, when sixteen 1 (Mword) x 1 (bit) semiconductor memory elements are used, a memory apparatus having a memory capacity of 2 Mbytes can be constituted. In this case, every time the number of semiconductor memory elements is increased by 16, the memory capacity can be increased in units of 2 Mbytes.

In this manner, a memory apparatus can be constituted by a plurality of semiconductor memory elements of the same type. Typical memory apparatuses are summarized in Table 1 below.

Table 1

| Data Bus Width | Type of Memory Element Used | Required Number of Memory Elements | Capacity of Memory Apparatus |
|---|---|---|---|
| 32 Bits | 128 Kwords x 8 Bits | Integer Multiple of 4 | Integer Multiple of 512 Kbytes |
| 32 Bits | 256 Kwords x 4 Bits | Integer Multiple of 8 | Integer Multiple of 1 Mbyte |
| 32 Bits | 1 Mword x 1 Bit | Integer Multiple of 32 | Integer Multiple of 4 Mbytes |
| 32 Bits | 512 Kwords x 8 Bits | Integer Multiple of 4 | Integer Multiple of 2 Mbytes |
| 32 Bits | 1 Mword x 4 Bits | Integer Multiple of 8 | Integer Multiple of 4 Mbytes |
| 32 Bits | 4 Mwords x 1 Bit | Integer Multiple of 32 | Integer Multiple of 16 Mbytes |
| 16 Bits | 128 Kwords x 8 Bits | Integer Multiple of 2 | Integer Multiple of 256 Kbytes |
| 16 Bits | 256 Kwords x 8 Bits | Integer Multiple of 4 | Integer Multiple of 512 Kbytes |
| 16 Bits | 1 Mword x 1 Bit | Integer Multiple of 16 | Integer Multiple of 2 Mbytes |
| 16 Bits | 512 Kwords x 8 Bits | Integer Multiple of 2 | Integer Multiple of 1 Mbyte |
| 16 Bits | 1 Mword x 4 Bits | Integer Multiple of 4 | Integer Multiple of 2 Mbytes |
| 16 Bits | 4 Mwords x 1 Bit | Integer Multiple of 16 | Integer Multiple of 8 Mbytes |
| 8 Bits | 128 Kwords x 8 Bits | Integer Multiple of 1 | Integer Multiple of 128 Kbytes |
| 8 Bits | 256 Kwords x 4 Bits | Integer Multiple of 2 | Integer Multiple of 256 Kbytes |
| 8 Bits | 1 Mword x 1 Bit | Integer Multiple of 8 | Integer Multiple of 1 Mbyte |

However, as can be understood from the above description and the contents of Table 1, when a memory apparatus is constituted by using a plurality of semiconductor memory elements of the same type, the capacity of the memory apparatus is limited to an integer multiple of a minimum capacity in accordance with its data bus width and combinations of semiconductor memory elements used.

For example, when a memory apparatus for a microprocessor having a 16-bit data bus width is to be constituted by 256 (Kwords) x 4 (bits) memory elements, if four memory elements are used, a 512-Kbyte memory apparatus can be arranged. However, since the next largest memory capacity is 1 Mbyte using eight memory elements, an intermediate memory capacity of 640 Kbytes cannot be obtained.

A value "640 Kbytes" is very significant at present. More specifically, as an operating system of existing personal computers, a disk operating system (DOS) is most widely used. The DOS requires 640 Kbytes as the standard main memory capacity. Therefore, a memory apparatus having a memory capacity of exactly 640 Kbytes is required. In practice, almost all presently commercially available personal computers are equipped with 640-Kbyte main memories. The 640-Kbyte memory apparatus cannot be constituted by a combination of semiconductor memory elements of the same type but is constituted by combining two or more types of semiconductor memory elements.

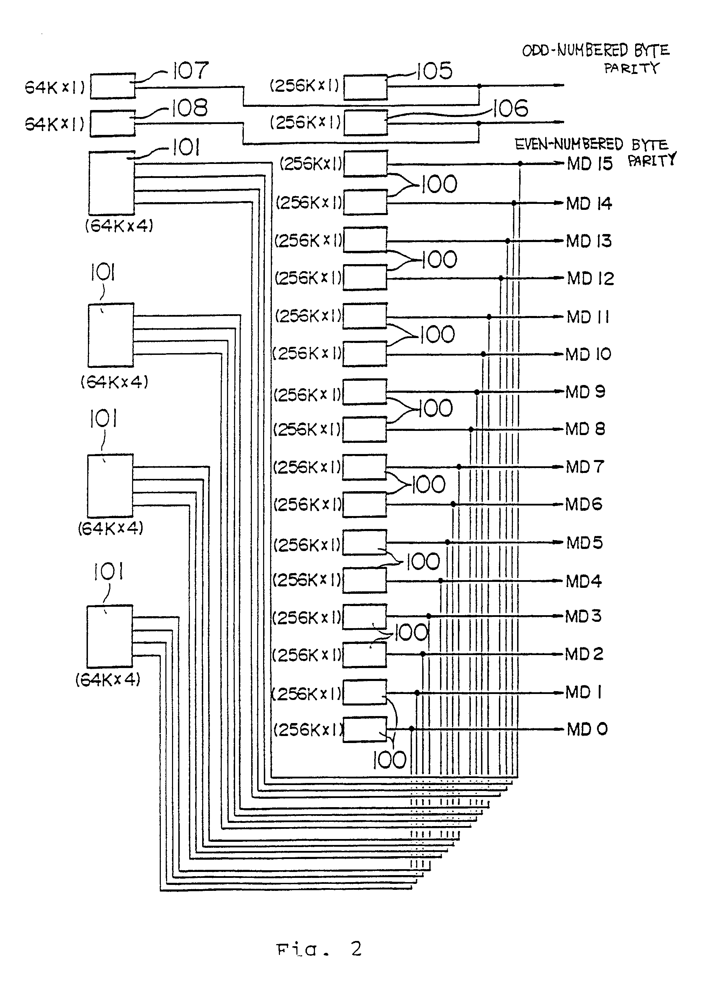

More specifically, in order to constitute the 640-Kbyte memory apparatus, sixteen 256 (Kwords) x 1 (bit) 256-Kbit DRAMs (to be referred to as 256K x 1 256K DRAMs hereinafter) and four 64 (Kwords) x 4 (bits) 256-Kbit DRAMs (to be referred to as 64K x 4 256K DRAMs hereinafter) are used, as shown in Fig. 2, for the following reason. That is, the 256K DRAMs are most advantageous in terms of cost, and can be amply supplied. In Fig. 2, the 256K x 1 256K DRAMs are denoted by reference numeral 100, and the 64K x 4 256K DRAMs are denoted by reference numeral 101. Note that Fig. 2 shows only connections of data terminals of the DRAMs, and does not particularly show address and control terminals (RAS, CAS, and WE signals). That is, the connections of the data terminals are important in the present invention, but those of other terminals are not so important and can be easily understood by those who are skilled in the design of personal computers even if they are omitted. Therefore, the connections of other terminals are omitted here to clarify the gist of the present invention.

In Fig. 2, a 512-Kbyte memory (256 Kwords x 16 bits) is constituted by sixteen 256K x 1 DRAMs, a 128-Kbyte memory (64 Kwords x 16 bits) is constituted by four 64K x 4 DRAMs, and their data bus lines (MD15 to MD0) are connected in parallel with each other to constitute a 640-Kbyte memory apparatus (320 Kwords x 16 bits) as a whole. The 16-bit data bus (MD15 to MD0) of the memory is connected to a data bus of a microprocessor having a 16-bit data bus width through a buffer (not shown).

Note that reference numerals 105 and 106 denote 256K x 1 parity-bit DRAMs; and 107 and 108, 64K x 1 parity-bit DRAMs. The DRAMs 105 and 107 correspond to upper 8 bits (odd-numbered byte), and the DRAMs 106 and 108 correspond to lower 8 bits (even-numbered byte). For parity bits, four 1-bit output DRAMs 105 to 108 are used. However, the parity-bit DRAM may be constituted by one 4-bit output DRAM. Since parity bits of the memory apparatus are not directly related to the present invention, they will be omitted in the following description.

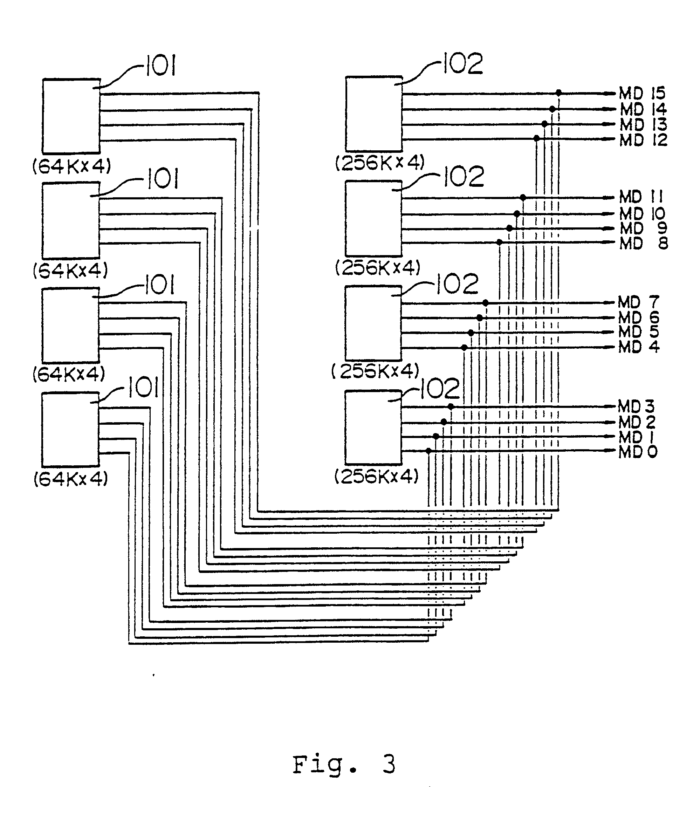

In Fig. 2, a total of twenty 256K DRAMs are used. Along with the progression of semiconductor techniques, main products tend to shift from 256K DRAMs to 1M DRAMs. With this tendency, the manufacturers of personal computers tend to frequently use 1M DRAMs. The 640-Kbyte memory apparatus is constituted by a total of eight DRAMs, i.e., four 256 (Kwords) x 4 (bits) 1-Mbit DRAMs (to be referred to as 256K x 4 1M DRAMs hereinafter) and four 64K x 4 256K DRAMs, as shown in Fig. 3. More specifically, four 64K x 4 256K DRAMs are used to constitute a 128-Kbyte memory (64 Kwords x 16 bits), and four 256K x 4 1M DRAMs 102 are used to constitute a 512-Kbyte memory (256 Kwords x 16 bits). These memories are combined to constitute a 640-Kbyte (320 Kwords x 16 bits) memory apparatus. A 16-bit data bus (MD15 to MD0) of the memory is connected to the data bus of the microprocessor through the buffer as in Fig. 2. In the memory apparatus shown in Fig. 3, the sixteen 256K x 1 256K DRAMs shown in Fig. 2 are replaced with the four 256K x 4 1M DRAMs. However, the four 64K x 4 256K DRAMs in Fig. 2 cannot be replaced with a 1M DRAM. If these DRAMs are replaced with the 1M DRAM, a 64 (KWords) x 16 (bits) 1-Mbit DRAM is necessary. However, such a DRAM is not commercially available. If such a DRAM were available, cost would be increased since it would be a special one, and the number of pins wound be large, resulting in a large package. Since 16 data bus lines would extend from a single package, noise would be increased, and a stable operation would not be assured.

Therefore, almost all 640-Kbyte memory apparatuses are constituted, as shown in Fig. 3, at present.

In this manner, when a memory apparatus having a 16-bit data bus width is constituted by, e.g., 256K x 4 memory elements by a conventional method of constituting a memory apparatus, a 512-Kbyte or 1-Mbyte apparatus can be constituted, but a 640-Kbyte apparatus is not available. In order to constitute the 640-Kbyte memory apparatus by the conventional technique, four 64K x 4 256K DRAMs are necessary in addition to four 256K x 4 1M DRAMs.

Recently, however, the manufacturers of semiconductors tend to rapidly shift their main products to 1M DRAMs, tend to decrease the production quantities of 256K DRAMs, and plan to stop production of 256K DRAMs. Therefore, it is very difficult to obtain 256K DRAMs, and the production quantities of personal computers
are restricted by supply quantities of 256K DRAMs. In addition, the cost of 256K DRAMs is also increased. Thus, an important problem for the manufacturers of personal computers is to develop personal computers which do not require 256K DRAMs.

This problem is generally expressed as follows. More specifically, semiconductor memory elements of one type tend to be intensively manufactured according to current needs. For this reason, semiconductor memory elements other than those which are intensively manufactured cannot be supplied in large quantities, resulting in high cost.

If a memory apparatus is constituted by using only semiconductor memory elements of one type, which are mass-produced in the largest quantities at that time, a memory apparatus and a personal computer adopting the memory apparatus can be supplied at low cost without restricting their production quantities.

## SUMMARY OF THE INVENTION :

It is an object of the present invention to provide a memory apparatus which uses semiconductor memory elements of one type, and has a high degree of freedom about its memory capacity, in other words, can set its memory capacity in relatively small units.

In order to achieve the above object, a memory apparatus of the present invention has a $W(1 + J/N)$ (words) x D (bits) configuration using $(N + J)$ ($N = D/B = 2^{d-b}$; J is a positive integer satisfying $J < N$) W (words) x B (bits) ($W = 2^w$ where $w$ is a positive integer; $B = 2^b$ where $b$ is zero or a positive integer satisfying $b < d$) semiconductor memory elements. More specifically, a $\overline{W}$-word address area of each semiconductor memory element is equally divided into P ($P = N \cdot L/J$ where P and L are positive integers) divided element address areas $a_1$, $a_2$,..., $a_P$, and a $W(1 + J/N)$-word memory address area is divided in units of W/P words to be expressed by $(P + L)$ divided memory address areas $A_1$, $A_2$,..., $A_{P+L}$. A plurality of sets of N divided element address areas selected from all the $P(N + J)$ divided element address areas while avoiding repetitions of semiconductor memory elements are formed, and each set is caused to correspond to one of the divided memory address areas $A_1$, $A_2$,..., $A_{P+L}$.

For example, five 256K x 4 1M DRAMs are used, so that four out of five DRAMs always correspond to access from a microprocessor. Furthermore, a 640-Kbyte memory address space is equally divided into five 128-Kbyte memory address areas, and the correspondence between the 128-Kbyte divided memory address areas and four out of the five DRAMs is regularly determined in turn, thus constituting a 640-Kbyte memory apparatus (320 Kwords x 16 bits) by only the 1M DRAMs.

Thus, according to the present invention, the memory capacity can be set in relatively small units, i.e., in units of $W \cdot J/N$ words x D bits using only semiconductor memory elements of one type.

## BRIEF DESCRIPTION OF THE DRAWINGS :

Fig. 1A is a block diagram showing connections between a CPU and a memory apparatus according to an embodiment of the present invention;
Fig. 1B is a block diagram showing an internal arrangement of the memory apparatus according to the embodiment of the present invention;
Fig. 1C is a table showing the correspondence between address areas of a microprocessor and DRAMs;
Fig. 1D shows terminals of a 256K x 4 1M DRAM;
Fig. 1E shows addresses in the DRAM;
Fig. 1F is a detailed table of Fig. 1C;
Figs. 1G-1 and 1G-2 are circuit diagrams showing a control circuit for address terminals of the DRAMs;
Fig. 1H is a view showing the principle of the present invention;
Figs. 2 and 3 are block diagrams showing the conventional memory apparatuses;
Fig. 4 is a table for explaining a second embodiment of the present invention;
Fig. 5 is a table for explaining a third embodiment of the present invention;
Fig. 6 is a table for explaining a fourth embodiment of the present invention; and

Fig. 7 is a table comparing available memory capacities of the conventional memory apparatuses and those of the present invention.

DETAILED DESCRIPTION OF THE PREFERRED EMBODIMENTS :

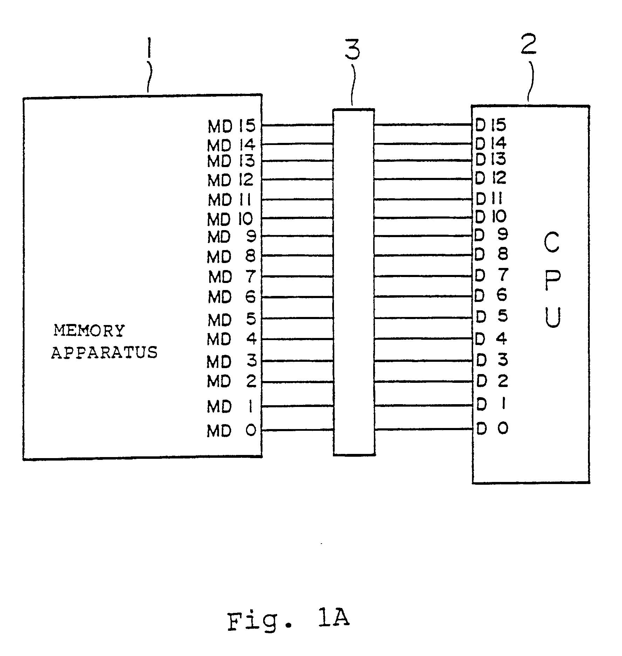

Fig. 1A shows an embodiment of a personal computer including a memory apparatus according to the present invention. The data bus width of the memory apparatus 1 according to the present invention is of 16 bits. Reference numerals MD15 to MD0 denote data bus lines of a memory. A microprocessor 2 has a 16-bit data bus (D15 to D0 are data bus lines of the microprocessor 2). The data bus lines and a buffer 3 are inserted between the memory apparatus 1 and the microprocessor 2.

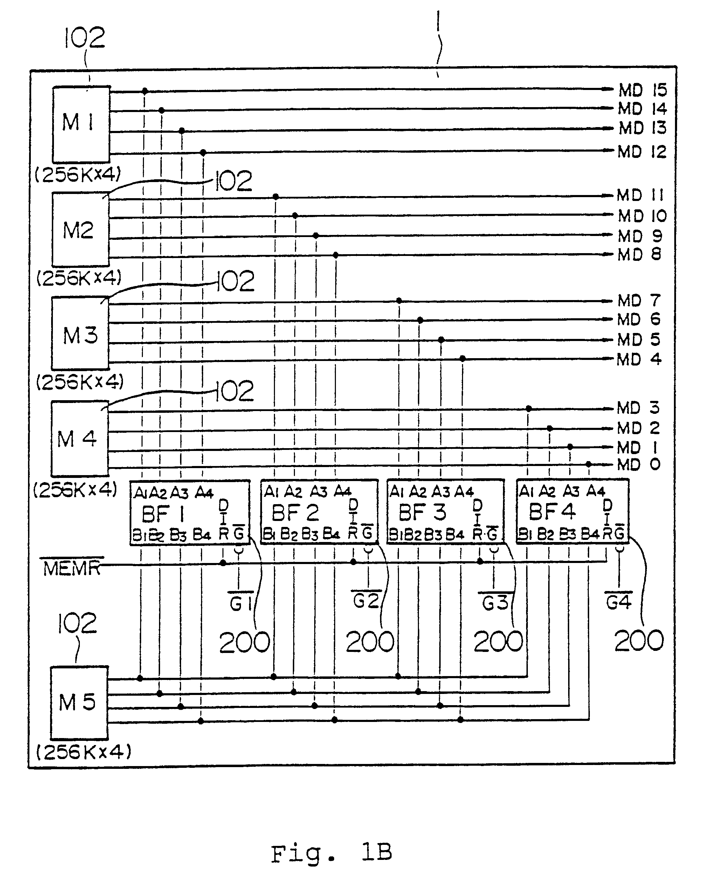

Fig. 1B illustrates in detail the memory apparatus 1 in Fig. 1A.

Five 256K x 4 1M DRAMs 102 constitute a 640-Kbyte memory apparatus. The five 1M DRAMs 102 are named M1, M2, M3, M4, and M5, as shown in Fig. 1B. Lines MD15 to MD0 constitute a 16-bit memory data bus, and are connected to the microprocessor through the buffer 3. Bidirectional buffers 200 are enabled when their enable terminals $\overline{G}$ are at low (to be referred to as L hereinafter) level. The direction of each buffer is determined according to the value of a direction control buffer DIR at that time. When the terminal DIR is at high (to be referred to as H hereinafter) level, each buffer drives from terminals A (A1 to A4) to terminals B (B1 to B4); when the terminal DIR is at L level, the buffer drives from terminals B to terminals A. When the terminal $\overline{G}$ is at H level, the corresponding buffer 200 is disabled, and the terminals A and B are disconnected. The functions of each bidirectional buffer 200 are summarized in Table 2 below.

Table 2

| (Functions of Buffer 200) | | |
|---|---|---|
| $\overline{G}$ | DIR | Operations of Buffer |
| L | L | B (B1 to B4) → A (A1 to A4) |
| L | H | A (A1 to B4) → B (B1 to B4) |
| H | - | A and B are disconnected |

Note that the four buffers 200 are named as BF1, BF2, BF3, and BF4 from the left, and signals at the terminals $\overline{G}$ of these buffers are represented by $\overline{G1}$, $\overline{G2}$, $\overline{G3}$, and $\overline{G4}$. The terminals DIR of the buffers are commonly connected, and an $\overline{MEMR}$ signal is input thereto. The $\overline{MEMR}$ signal goes to L level when a read command is executed for the memory apparatus 1. More specifically, in a memory read mode, the buffers 200 drive from the terminals B to the terminals A; in other modes, the buffers 200 drive from the terminals A to the terminals B.

Prior to a description of the operation of Fig. 1B, memory addresses of this embodiment will be described below. In Fig. 1A, a description about an address bus is omitted. In this embodiment, the memory apparatus 1 is assumed to be allocated on 640 Kbytes from 00000H to 9FFFFH on a memory address space of the microprocessor 2 (H appended at the end of an address is a symbol indicating the hexadecimal notation).

The 640-Kbyte address space occupied by the memory apparatus 1 is equally divided into five spaces, and the five 128-Kbyte address spaces will be referred to as divided memory address areas $A_1$, $A_2$, $A_3$, $A_4$, and $A_5$ hereinafter. In this embodiment, a 128-Kbyte area from 000000H to 1FFFFH is the area $A_1$; 20000H to 3FFFFH, $A_2$; 40000H to 5FFFFH, $A_3$; 60000H to 7FFFFH, $A_4$; and 80000H to 9FFFFH, $A_5$.

A case will be examined below wherein the microprocessor 2 executes memory read access of the area $A_1$ (00000H to 1FFFFH). In this case, of five DRAMs, the DRAMs M2, M3, M4, and M5 respectively output 4-bit data. The remaining DRAM M1 does not respond at all, and outputs no memory data. More specifically, the DRAM M2 outputs memory data to the lines MD11 to MD8, the DRAM M3 outputs memory data to the lines MD7 to MD4, and the DRAM M4 outputs memory data to the lines MD3 to MD0. In a memory read mode of the area $A_1$, only the buffer BF1 of the four buffers BF1, BF2, BF3, and BF4 is enabled ( $\overline{G1}$ = L, $\overline{G2}$ = $\overline{G3}$ = $\overline{G4}$ = H). In addition, since the DIR signal ( = $\overline{MEMR}$ ) of each buffer is at L level, memory data read out from the DRAM M5 is output to the lines MD15 to MD12 through the buffer BF1. As described above, memory data are read out from the DRAMs M5, M2, M3, and M4 onto the lines MD15 to MD0. Memory write access of the area $A_1$ is executed in the same manner as in the memory read

6

access except for the direction of data flow, and a detailed description thereof will be omitted. In the following description, a description only about memory read access will be made, and that of memory write access will be omitted.

In a memory read mode of the area $A_2$ (20000H to 3FFFFH), the DRAMs M1, M3, M4, and M5 respond, and only the buffer BF2 is enabled ( $\overline{G2}$ = L, $\overline{G1}$ = $\overline{G3}$ = $\overline{G4}$ = H).

In this case, the DRAM M1 outputs data onto the lines MD15 to MD12, the DRAM M5 outputs data onto the lines MD11 to MD8 through the buffer BF2, the DRAM M3 outputs data onto the lines MD7 to MD4, and the DRAM M4 outputs data onto the lines MD3 to MD0.

Similarly, in a memory read mode of the area $A_3$ (40000H to 5FFFFH), four DRAMs, i.e., M1 (MD15 to MD12), M2 (MD11 to MD8), M5 (MD7 to MD4), and M4 (MD3 to MD0) respond. In a memory read mode of the area $A_4$ (60000H to 7FFFFH), four DRAMs, i.e., M1 (MD15 to MD12), M2 (MD11 to MD8), M3 (MD7 to MD4), and M5 (MD3 to MD0) respond.

In a memory read mode of the area $A_5$, four DRAMs, i.e., M1 (MD15 to MD12), M2 (MD11 to MD8), M3 (MD7 to MD4), and M4 (MD3 to MD0) respond. In this case, all the four buffers 200 (BF1 to BF4) are disabled.

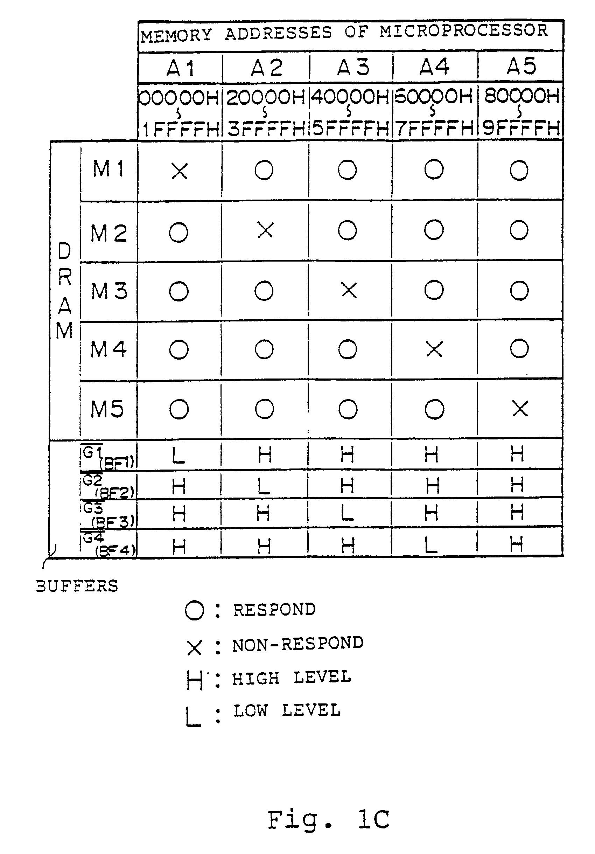

As described above, in the memory apparatus shown in Fig. 1B, in response to access from the microprocessor, four out of the five DRAMs always respond to generate 16-bit memory data. Fig. 1C summarizes the correspondence between the memory addresses of the microprocessor 2 and the DRAMs 102 (M1 to M5), and the relationship with the buffers 200 (BF1 to BF4).

With the above mechanisms, the 640-Kbyte memory apparatus (320 Kwords x 16 bits) can be constituted by five 256K x 4 1M DRAMs. For the purpose of a supplementary explanation, each DRAM will be further explained.

The correspondence with the data bus will be described below. In the present invention, four DRAMs need only correspond to memory address areas of the microprocessor, and the four DRAMs need only have a one-to-one correspondence with the corresponding lines of the 16-bit data bus without overlapping each other. However, if the correspondence is not regular, the number of buffers between the lines MD15 to MD0 and the DRAMs (M1 to M5) is undesirably increased. In the embodiment shown in Fig.1B, the four DRAMs 200 (M1 to M4) permanently correspond to the lines MD15 to MD12, MD11 to MD8, MD7 to MD4, and MD3 to MD0, respectively. Only the DRAM M5 corresponds to one set of the lines MD15 to MD12, MD11 to MD8, MD7 to MD4, and MD3 to MD0 depending on the selected memory address area. Therefore, four buffers are required between the DRAM5 and the memory data bus lines MD15 to MD0. For the DRAMs M1 to M4, no buffer is required. In the embodiment shown in Fig. 1B, a total of only four buffers 200 are necessary. In this embodiment, the number of buffers is smallest.

The correspondence between internal addresses of each DRAM and the memory addresses of the microprocessor will be described below.

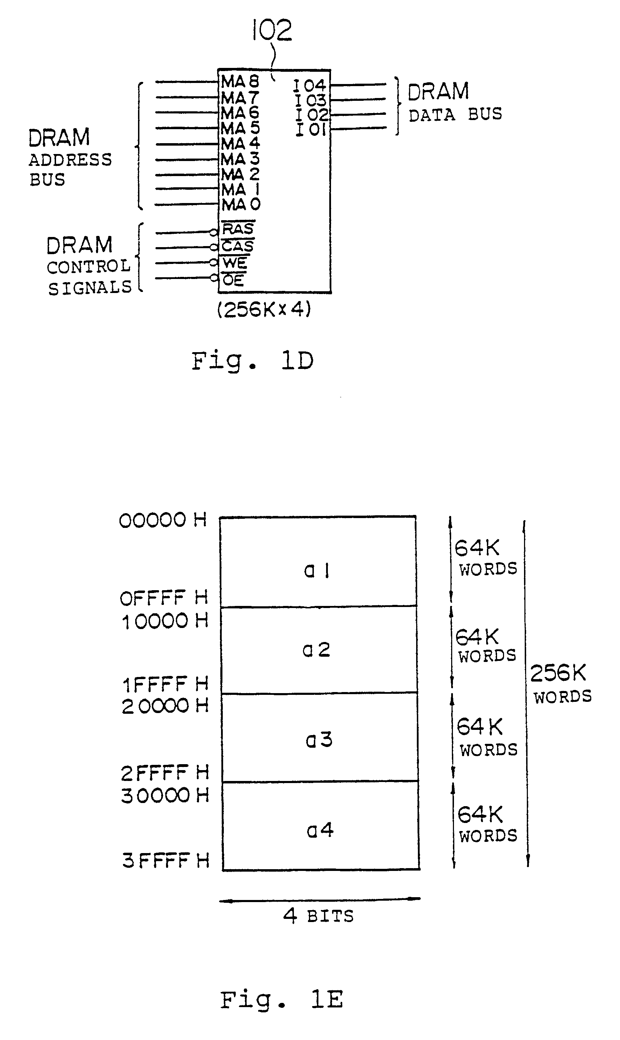

The 256K x 4 1M DRAM will be briefly described. Fig. 1D shows pin allocation of the 1M DRAM 102 used in the embodiment shown in Fig. 1B, and is generally commercially available. Reference numerals IO4 to IO1 denote 4-bit data bus lines of the DRAM. In Fig. 1B only these data bus lines are connected. Reference numerals MA8 to MA0 denote nine DRAM address bus lines, to which nine row addresses and nine column addresses are multiplexed and input. Reference symbols $\overline{RAS}$, $\overline{CAS}$, $\overline{WE}$, and $\overline{OE}$ denote control signals for the DRAM, which are used for read/write control.

The DRAM shown in Fig. 1D has a 256 (Kwords) x 4 (bits) configuration. Of 256 Kwords, one word is selected by the address bus lines MA8 to MA0. In the internal structure of the DRAM, as shown in Fig. 1E, 256-Kword area is divided into four areas, and the divided areas are respectively represented by divided element address areas $a_1$, $a_2$, $a_3$, and $a_4$. More specifically, when the internal addresses of the DRAM are represented by 00000H to 3FFFFH, addresses 00000H to 0FFFFH correspond to the area $a_1$; 10000H to 1FFFFH, $a_2$; 20000H to 2FFFFH, $a_3$; and 30000H to 3FFFFH, $a_4$.

As can be seen from Fig. 1C, the five DRAMs (M1 to M5) respond to four areas of the divided memory address areas $A_1$ to $A_5$ of the microprocessor. For example, the DRAM M1 corresponds to four areas $A_2$, $A_3$, $A_4$, and $A_5$. The divided element address areas $a_1$ to $a_4$ have a one-to-one correspondence with the four areas $A_2$, $A_3$, $A_4$, and $A_5$. This correspondence should be a one-to-one correspondence, but any out of the various possible one-to-one correspondences nay be employed. In this embodiment, the area $A_2$ corresponds to the area $a_2$ of the DRAM M1; $A_3$, $a_3$; $A_4$, $a_4$; and $A_5$, $a_1$.

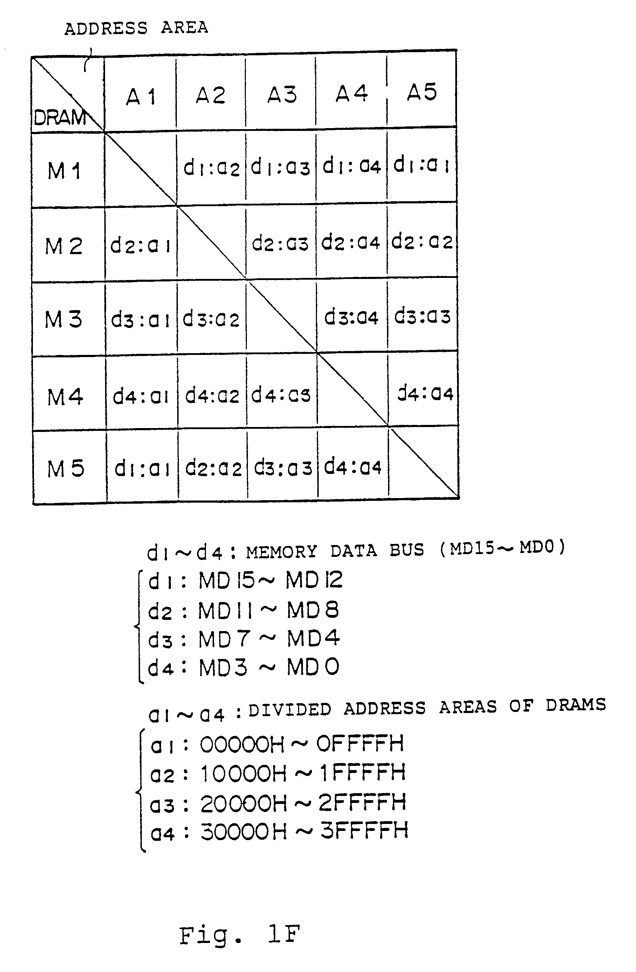

Similarly, the DRAM M2 corresponds to the four address areas $A_1$ (corresponding to $a_1$ of the DRAM M2), $A_3$ ($a_3$), $A_4$ ($a_4$), and $A_5$ ($a_2$). Each of the DRAMs M3, M4, and M5 similarly corresponds to the four address areas. Fig. 1F summarizes their correspondence. Fig. 1F summarizes the correspondence between the address areas ($A_1$ to $A_5$) of the microprocessor and the address areas ($a_1$ to $a_4$) in the DRAMs, and the relationship between the DRAM data and the memory data bus lines (MD15 to MD0).

The way of reading Fig. 1F will be briefly described. When the microprocessor 2 accesses the address area $A_1$, the column of $A_1$ can be checked vertically. The DRAM M1 does not respond, and the four DRAMs M2 to M5 respond. This column demonstrates that data in the area $a_1$ of the DRAM M2 corresponds to the lines MD11 to MD8 (indicated by d2), data in the area $a_1$ of the DRAM M3 corresponds to the lines MD7 to MD4 (indicated by d3), data in the area $a_1$ of the DRAM M4 corresponds to the lines MD3 to MD0 (indicated by d4), and data in the area $a_1$ of the DRAM4 corresponds to the lines MD15 to MD12 (indicated by d1). The same applies to the columns of $A_2$ to $A_5$.

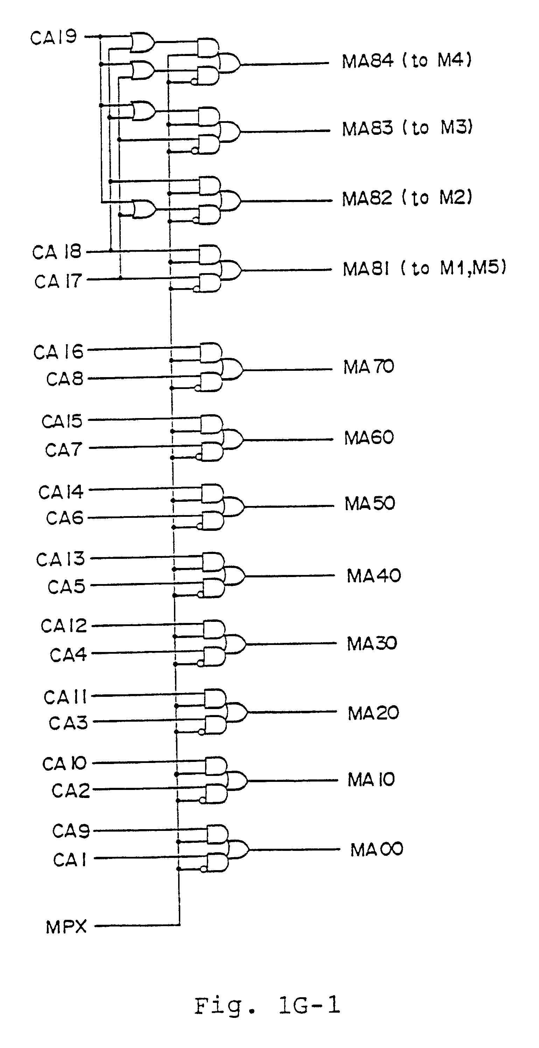

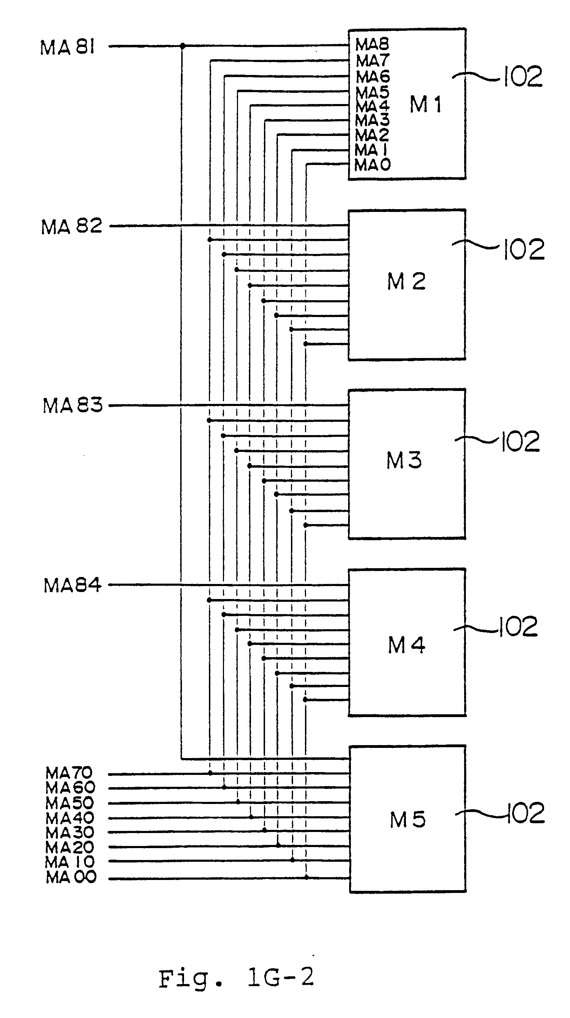

Figs. 1G-1 and 1G-2 show a circuit for controlling the address terminals MA8 to MA0 of the DRAMs M1 to M5. Reference numerals CA19 to CA1 denote address bus lines of the microprocessor 2, which are multiplexed in response to a control signal MPX to indicate addresses of the DRAM. When MPX = L, the row address is fetched in the DRAM; when MPX = H, the column address is fetched in the DRAM. Lines corresponding to lower 8 bits of an address (MA70 to MA00) are commonly connected to all the DRAMs. However, lines corresponding to the MSBs (most significant bits) are connected to different DRAMs. More specifically, a line MA81 is connected to the DRAMs M1 and M5, a line MA82 is connected to the DRAM M2, a line M83 is connected to the DRAM M3, and a line MA84 is connected to the DRAM M4.

In the above embodiment, a case has been exemplified wherein the 640-Kbyte memory apparatus is constituted by the five 256K x 4 1M DRAMs. However, the present invention is not limited to this, as has been described in the paragraph of the arrangement.

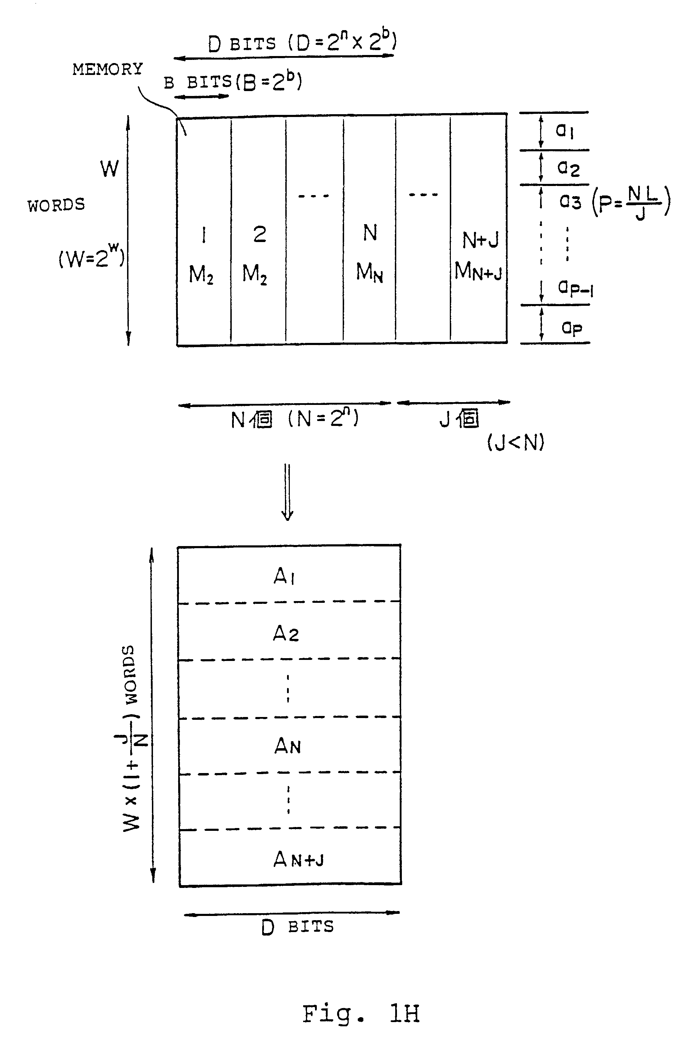

Fig. 1H shows the principle of the present invention. In the embodiment shown in Figs. 1A to 1G, parameters in Fig. 1H are as follows: $w = 18$, $W = 2^w = 256K$, $b = 2$, $B = 2^b = 4$, $n = 2$, $N = 2^n = 4$, $J = 1$, $D = 2^n \times 2^b = 16$, $L = 1$, and $P = N \cdot L/J = 4$.

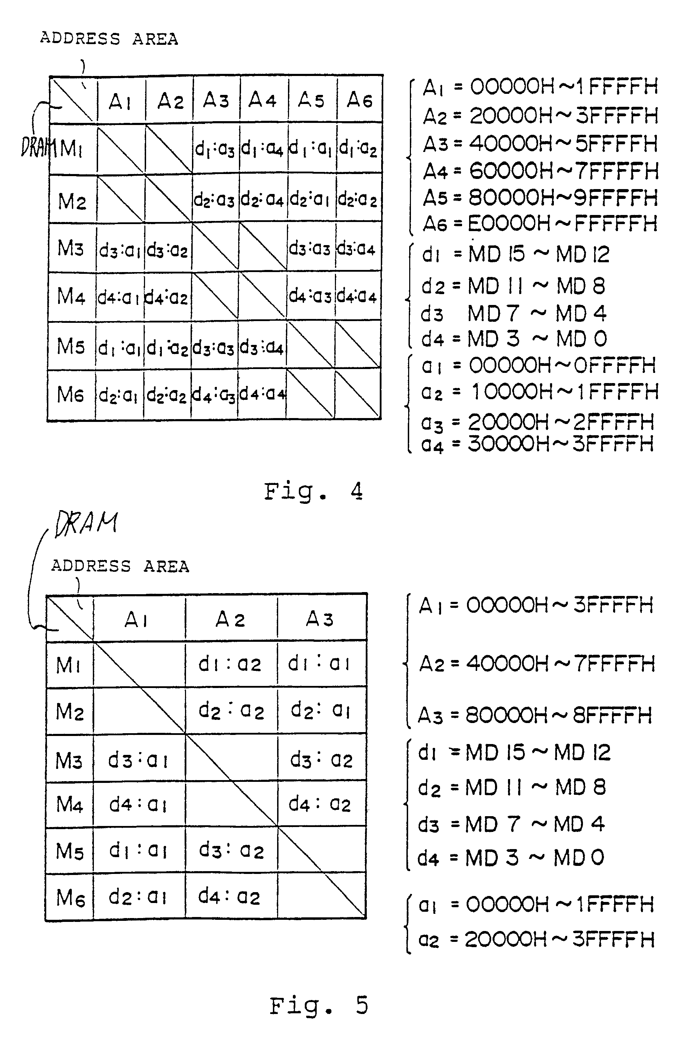

A second embodiment wherein a 768-Kbyte memory apparatus (384 Kwords x 16 bits) is constituted by six 256K x 4 1M DRAMs will be briefly described below with reference to Fig. 4. Fig. 4 corresponds to Fig. 1F in the first embodiment. M1 to M6 designate six DRAMs (256K x 4 configuration), and $A_1$ to $A_6$ designate 128-Kbyte address areas. Although the address areas $A_1$ to $A_5$ are the same as those in the first embodiment, the area $A_6$ is allocated in E0000H to FFFFH. More specifically, in this embodiment, the 768-Kbyte address areas are not continuous. This implies that the address areas of the memory need not always be continuous in the memory apparatus of the present invention. In Fig. 4, d1 to d4 and $a_1$ to $a_4$ have the same meanings as those in Fig. 1F.

In this embodiment, four out of the six DRAMs always correspond to the address areas $A_1$ to $A_6$. The DRAMs M1 to M6 correspond to four out of six address areas. As for the correspondence with the data bus, the DRAM M1 always corresponds to d1 (MD15 to MD12); M2, d2 (MD11 to MD8); M3, d3 (MD7 to MD4); and M4, d4 (MD3 to MD0). Meanwhile, the DRAM M5 corresponds to d1 in association with the address areas $A_1$ and $A_2$, and corresponds to d3 in association with the address areas $A_3$ and $A_4$. The DRAM M6 corresponds to d2 in association with the areas $A_1$ and $A_2$, and corresponds to d4 in association with the areas $A_3$ and $A_4$. Although a detailed circuit arrangement is omitted here, it will be easily understood from the above descriptions.

In this embodiment, parameters in Fig. 1H are set as follows: $w = 18$, $W = 2^w = 256K$, $b = 2$, $B = 2^b = 4$, $n = 2$, $N = 2^n = 4$, $J = 2$, $D = 2^n \times 2^b = 16$, $L = 2$, and $P = N \cdot L/J = 4$.

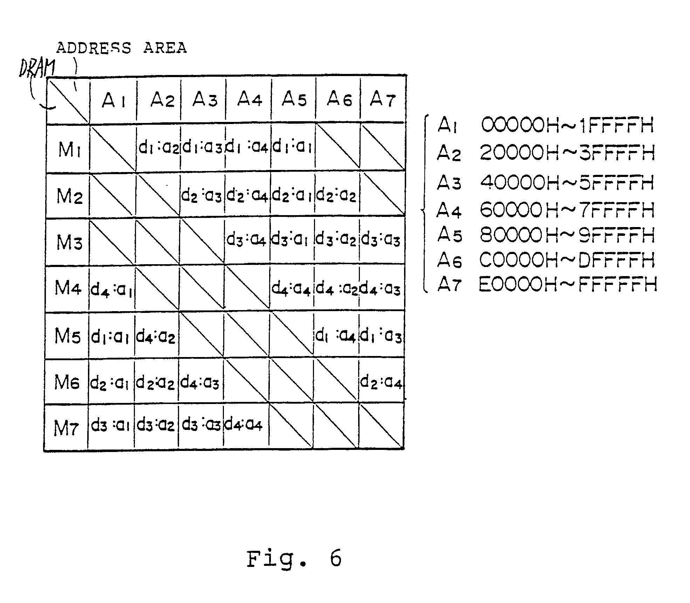

In the third embodiment shown in Fig. 5, a 768-Kbyte memory apparatus (384 Kwords x 16 bits) is constituted by six 256K x 4 1M DRAMs in the same manner as in the second embodiment. A difference between the third and second embodiments is the way of dividing the internal addresses of the 1 M DRAM as a semiconductor memory element. In the second embodiment, the 256-Kword element internal address space is divided into four 64-Kword address areas $a_1$ to $a_4$ in the same manner as in the first embodiment. In the third embodiment, the 256-Kword element internal address space is equally divided into two 128-Kword areas $a_1$ and $a_2$. The address space of the memory is accordingly divided into three address areas $A_1$ to $A_3$ in units of 128 Kwords The difference between the third and second embodiments will be demonstrated by parameters shown in Fig. 1H. That is, the values of the numbers of divisions P of the internal address space of the semiconductor memory element, and, hence, the values L differ from each other. More specifically, in the second embodiment, $L = 2$ and $P = N \cdot L/J = 4$, while in the third embodiment, $L = 1$ and $P = 2$. Other parameters are the same as those in the second embodiment.

Fig. 6 shows the fourth embodiment wherein a 896-Kbyte memory apparatus (448 Kwords x 16 bits) is constituted by seven 256K x 4 1M DRAMs. Parameters shown in Fig. 1H of this embodiment are set as follows: $w = 18$, $W = 2^w = 256K$, $b = 2$, $B = 2^b = 4$, $n = 2$, $N = 2^n = 4$, $J = 3$, $D = 2^n \times 2^b = 16$, $L = 1$, and $P = N \cdot L/J = 4$. The principle of this embodiment is the same as those in the first to third embodiments, and a detailed description thereof will be omitted.

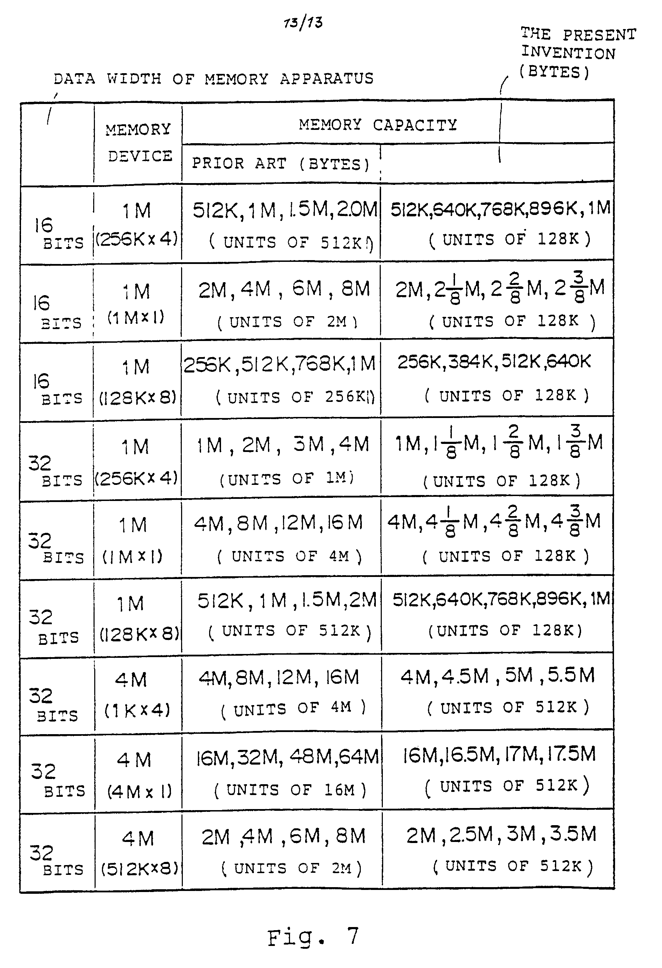

Fig. 7 is a table showing available memory capacities by the memory apparatuses of the present invention in comparison with those of conventional apparatuses when semiconductor memory elements of the same type are used.

According to the present invention, a memory apparatus is constituted by semiconductor memory elements of one type. The memory apparatus of the present invention can be connected in parallel with another memory apparatus if the number of bits is the same. In this case, the other memory apparatus may be one constituted by only semiconductor memory elements of one type according to the present invention or an existing memory apparatus constituted by a plurality of types of semiconductor memory elements.

As described above, according to the memory apparatus of the present invention, a memory capacity can be set in relatively small units using only semiconductor memory elements of one type. For example, when a memory apparatus having a 16-bit width is to be constituted by 256K x 4 1M DRAMs, memory apparatuses having memory capacities of 512 Kbytes, 1 Mbyte, 1.5 Mbyte, 2 Mbyte,..., i.e., apparatuses in units of 512 Kbytes can only be obtained according to the conventional technique. However, according to the present invention, memory apparatuses having memory capacities of 512 Kbytes, 640 Kbytes, 768 Kbytes, 896 Kbytes, 1 Mbyte, (1 + 1/8) Mbytes,..., i.e., apparatuses in units of 128 Kbytes (1/8 Mbytes) can be constituted.

Therefore, a 640-Kbyte memory apparatus which is most popular in the field of personal computers can be constituted by five 1-Mbit DRAMs. As compared to a total of eight DRAMs, i.e., four 1M DRAMs and four 256K DRAMs of the conventional memory apparatus, the memory apparatus of the present invention is very advantageous in terms of cost (price), space (mounting area), power (power consumption), and supply.

## Claims

1. A memory apparatus having a data bus of a D-bit (D = $2^d$ where $d$ is a positive integer) width and a memory capacity of W(1 + J/N) words x D bits, comprising:

(N + J) (N = D/B = $2^{d-b}$; J is a positive integer satisfying J < N) semiconductor memory elements each having a W (words) x B (bits) (W = $2^w$ where $w$ is a positive integer; B = $2^b$ where $b$ is zero or a positive integer satisfying b < d) configuration.

2. A memory apparatus according to claim 1,

wherein a W-word address area of each of said semiconductor memory elements is equally divided into P (P = $N \cdot L/J$; P and L are positive integers) divided element address areas $a_1$, $a_2$,..., $a_P$,

a W(1 + J/N)-word memory address area is divided in units of W/P words and the divided areas are represented by (P + L) divided memory address areas $A_1$, $A_1$,..., $A_{P+L}$,

a plurality of sets of N divided element address areas selected from all the P(N + J) divided element address areas while avoiding repetitive selections of the semiconductor memory elements are formed, and each set of N divided element address areas is caused to correspond to one of the divided memory address areas $A_1$, $A_2$,..., $A_{P+L}$.

3. A memory apparatus according to claim 1 or 2, wherein each of specific N semiconductor elements of the (N + J) semiconductor memory elements corresponds to one of N sections, obtained by dividing the D-bit memory data bus in units of B bits, without overlapping the remaining specific semiconductor memory elements.

4. A memory apparatus according to claim 3, wherein the semiconductor memory elements other than said specific semiconductor memory elements are connected to corresponding ones of the sections of the memory data bus through bidirectional buffers which can be ON/OFF-controlled and direction-controlled.

5. A memory apparatus of any one of claims 1 to 4 connected to another memory apparatus having the same data bit width.

6. A memory apparatus according to any one of claims 2 to 4, wherein D = 16 (d = 4), W = 256K (w = 18), B = 4 (b = 2), N = 4 (n = 2), J = 1, L = 1, and the memory capacity is of 640 Kbytes.

Fig. 1A

Fig. 1B

| | | MEMORY ADDRESSES OF MICROPROCESSOR | | | | |
| --- | --- | --- | --- | --- | --- | --- |
| | | A1 | A2 | A3 | A4 | A5 |
| | | 00000H ∿ 1FFFFH | 20000H ∿ 3FFFFH | 40000H ∿ 5FFFFH | 60000H ∿ 7FFFFH | 80000H ∿ 9FFFFH |
| D R A M | M1 | ✕ | ◯ | ◯ | ◯ | ◯ |
| | M2 | ◯ | ✕ | ◯ | ◯ | ◯ |
| | M3 | ◯ | ◯ | ✕ | ◯ | ◯ |
| | M4 | ◯ | ◯ | ◯ | ✕ | ◯ |
| | M5 | ◯ | ◯ | ◯ | ◯ | ✕ |
| | G1 (BF1) | L | H | H | H | H |
| | G2 (BF2) | H | L | H | H | H |
| | G3 (BF3) | H | H | L | H | H |
| | G4 (BF4) | H | H | H | L | H |

BUFFERS

◯ : RESPOND

✕ : NON-RESPOND

H : HIGH LEVEL

L : LOW LEVEL

Fig. 1C

12

102

DRAM
ADDRESS
BUS

MA 8
MA 7
MA 6
MA 5
MA 4
MA 3
MA 2
MA 1
MA 0

I O4
I O3
I O2
I O1

DRAM
DATA BUS

DRAM
CONTROL
SIGNALS

$\overline{RAS}$
$\overline{CAS}$
$\overline{WE}$
$\overline{OE}$

(256K x 4)

Fig. 1D

00000 H

a 1

64K
WORDS

0FFFF H
10000 H

a 2

64K
WORDS

1FFFF H
20000 H

a 3

64K
WORDS

2FFFF H
30000 H

a 4

64K
WORDS

3FFFF H

256K
WORDS

4 BITS

Fig. 1E

ADDRESS AREA

| DRAM | A1 | A2 | A3 | A4 | A5 |
|------|------|------|------|------|------|
| M1 | | $d_1:a_2$ | $d_1:a_3$ | $d_1:a_4$ | $d_1:a_1$ |
| M2 | $d_2:a_1$ | | $d_2:a_3$ | $d_2:a_4$ | $d_2:a_2$ |
| M3 | $d_3:a_1$ | $d_3:a_2$ | | $d_3:a_4$ | $d_3:a_3$ |
| M4 | $d_4:a_1$ | $d_4:a_2$ | $d_4:a_3$ | | $d_4:a_4$ |
| M5 | $d_1:a_1$ | $d_2:a_2$ | $d_3:a_3$ | $d_4:a_4$ | |

$d_1 \sim d_4$ : MEMORY DATA BUS (MD15 $\sim$ MD0)

$d_1$ : MD 15 $\sim$ MD 12
$d_2$ : MD 11 $\sim$ MD 8
$d_3$ : MD 7 $\sim$ MD 4
$d_4$ : MD 3 $\sim$ MD 0

$a_1 \sim a_4$ : DIVIDED ADDRESS AREAS OF DRAMS

$a_1$ : 00000H $\sim$ 0FFFFH
$a_2$ : 10000H $\sim$ 1FFFFH
$a_3$ : 20000H $\sim$ 2FFFFH
$a_4$ : 30000H $\sim$ 3FFFFH

Fig. 1F

CA19 — MA84 (to M4)

MA83 (to M3)

MA82 (to M2)

CA 18 —
CA 17 — MA81 (to M1,M5)

CA 16 —
CA8 — MA70

CA15 —
CA7 — MA60

CA14 —
CA6 — MA50

CA13 —
CA5 — MA40

CA12 —
CA4 — MA30

CA11 —
CA3 — MA20

CA 10 —
CA2 — MA 10

CA9 —
CA1 — MA00

MPX —

Fig. 1G-1

Fig. 1G-2

Fig. 1H

Fig. 2

Fig. 3

ADDRESS AREA

DRAM M₁

| | A₁ | A₂ | A₃ | A₄ | A₅ | A₆ |
|---|---|---|---|---|---|---|
| M₁ | | | $d_1:a_3$ | $d_1:a_4$ | $d_1:a_1$ | $d_1:a_2$ |
| M₂ | | | $d_2:a_3$ | $d_2:a_4$ | $d_2:a_1$ | $d_2:a_2$ |
| M₃ | $d_3:a_1$ | $d_3:a_2$ | | | $d_3:a_3$ | $d_3:a_4$ |
| M₄ | $d_4:a_1$ | $d_4:a_2$ | | | $d_4:a_3$ | $d_4:a_4$ |
| M₅ | $d_1:a_1$ | $d_1:a_2$ | $d_3:a_3$ | $d_3:a_4$ | | |
| M₆ | $d_2:a_1$ | $d_2:a_2$ | $d_4:a_3$ | $d_4:a_4$ | | |

$\begin{cases} A_1 = 00000H \sim 1FFFFH \\ A_2 = 20000H \sim 3FFFFH \\ A_3 = 40000H \sim 5FFFFH \\ A_4 = 60000H \sim 7FFFFH \\ A_5 = 80000H \sim 9FFFFH \\ A_6 = E0000H \sim FFFFFH \end{cases}$

$\begin{cases} d_1 = MD\ 15 \sim MD\ 12 \\ d_2 = MD\ 11 \sim MD\ 8 \\ d_3\ \ MD\ 7 \sim MD\ 4 \\ d_4 = MD\ 3 \sim MD\ 0 \end{cases}$

$\begin{cases} a_1 = 00000H \sim 0FFFFH \\ a_2 = 10000H \sim 1FFFFH \\ a_3 = 20000H \sim 2FFFFH \\ a_4 = 30000H \sim 3FFFFH \end{cases}$

Fig. 4

DRAM

ADDRESS AREA

| | A₁ | A₂ | A₃ |
|---|---|---|---|
| M₁ | | $d_1:a_2$ | $d_1:a_1$ |
| M₂ | | $d_2:a_2$ | $d_2:a_1$ |
| M₃ | $d_3:a_1$ | | $d_3:a_2$ |
| M₄ | $d_4:a_1$ | | $d_4:a_2$ |
| M₅ | $d_1:a_1$ | $d_3:a_2$ | |
| M₆ | $d_2:a_1$ | $d_4:a_2$ | |

$\begin{cases} A_1 = 00000H \sim 3FFFFH \\ A_2 = 40000H \sim 7FFFFH \\ A_3 = 80000H \sim 8FFFFH \end{cases}$

$\begin{cases} d_1 = MD\ 15 \sim MD\ 12 \\ d_2 = MD\ 11 \sim MD\ 8 \\ d_3 = MD\ 7 \sim MD\ 4 \\ d_4 = MD\ 3 \sim MD\ 0 \end{cases}$

$\begin{cases} a_1 = 00000H \sim 1FFFFH \\ a_2 = 20000H \sim 3FFFFH \end{cases}$

Fig. 5

ADDRESS AREA

DRAM

| | A1 | A2 | A3 | A4 | A5 | A6 | A7 |
|---|---|---|---|---|---|---|---|
| M1 | | $d_1{:}a_2$ | $d_1{:}a_3$ | $d_1{:}a_4$ | $d_1{:}a_1$ | | |
| M2 | | | $d_2{:}a_3$ | $d_2{:}a_4$ | $d_2{:}a_1$ | $d_2{:}a_2$ | |
| M3 | | | | $d_3{:}a_4$ | $d_3{:}a_1$ | $d_3{:}a_2$ | $d_3{:}a_3$ |
| M4 | $d_4{:}a_1$ | | | | $d_4{:}a_4$ | $d_4{:}a_2$ | $d_4{:}a_3$ |
| M5 | $d_1{:}a_1$ | $d_4{:}a_2$ | | | | $d_1{:}a_4$ | $d_1{:}a_3$ |
| M6 | $d_2{:}a_1$ | $d_2{:}a_2$ | $d_4{:}a_3$ | | | | $d_2{:}a_4$ |
| M7 | $d_3{:}a_1$ | $d_3{:}a_2$ | $d_3{:}a_3$ | $d_4{:}a_4$ | | | |

$A_1$ 00000H~1FFFFH
$A_2$ 20000H~3FFFFH
$A_3$ 40000H~5FFFFH
$A_4$ 60000H~7FFFFH
$A_5$ 80000H~9FFFFH
$A_6$ C0000H~DFFFFH
$A_7$ E0000H~FFFFFH

Fig. 6

THE PRESENT
INVENTION
(BYTES)

DATA WIDTH OF MEMORY APPARATUS

| | MEMORY DEVICE | MEMORY CAPACITY | |
|---|---|---|---|
| | | PRIOR ART (BYTES) | |
| 16 BITS | 1M (256K×4) | 512K, 1M, 1.5M, 2.0M (UNITS OF 512K) | 512K, 640K, 768K, 896K, 1M (UNITS OF 128K) |
| 16 BITS | 1M (1M×1) | 2M, 4M, 6M, 8M (UNITS OF 2M) | 2M, $2\frac{1}{8}$M, $2\frac{2}{8}$M, $2\frac{3}{8}$M (UNITS OF 128K) |
| 16 BITS | 1M (128K×8) | 256K, 512K, 768K, 1M (UNITS OF 256K) | 256K, 384K, 512K, 640K (UNITS OF 128K) |
| 32 BITS | 1M (256K×4) | 1M, 2M, 3M, 4M (UNITS OF 1M) | 1M, $1\frac{1}{8}$M, $1\frac{2}{8}$M, $1\frac{3}{8}$M (UNITS OF 128K) |
| 32 BITS | 1M (1M×1) | 4M, 8M, 12M, 16M (UNITS OF 4M) | 4M, $4\frac{1}{8}$M, $4\frac{2}{8}$M, $4\frac{3}{8}$M (UNITS OF 128K) |
| 32 BITS | 1M (128K×8) | 512K, 1M, 1.5M, 2M (UNITS OF 512K) | 512K, 640K, 768K, 896K, 1M (UNITS OF 128K) |
| 32 BITS | 4M (1K×4) | 4M, 8M, 12M, 16M (UNITS OF 4M) | 4M, 4.5M, 5M, 5.5M (UNITS OF 512K) |
| 32 BITS | 4M (4M×1) | 16M, 32M, 48M, 64M (UNITS OF 16M) | 16M, 16.5M, 17M, 17.5M (UNITS OF 512K) |
| 32 BITS | 4M (512K×8) | 2M, 4M, 6M, 8M (UNITS OF 2M) | 2M, 2.5M, 3M, 3.5M (UNITS OF 512K) |

Fig. 7

| | DOCUMENTS CONSIDERED TO BE RELEVANT | | EP 90108448.3 |
| --- | --- | --- | --- |
| Category | Citation of document with indication, where appropriate, of relevant passages | Relevant to claim | CLASSIFICATION OF THE APPLICATION (Int. Cl. 5) |
| A | US - A - 4 592 022 (SHIMOHIGASHI) -- | | G 11 C 11/40 |
| A | US - A - 4 633 443 (CHILDERS) ---- | | |
| | | | TECHNICAL FIELDS SEARCHED (Int. Cl.5)

G 11 C |
| | The present search report has been drawn up for all claims | | |

| Place of search | Date of completion of the search | Examiner |
| --- | --- | --- |
| VIENNA | 09-11-1990 | GRÖSSING |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)